# EUROPÄISCHE PATENTSCHRIFT

(11) **EP 1 628 512 B1**
(45) Veröffentlichungstag und Bekanntmachung des Hinweises auf die Patenterteilung: **06.06.2007**
(21) Anmeldenummer: 05107373.2
(22) Anmeldetag: 11.08.2005
(51) Int. Cl.: H05K 5/02, H05K 5/04, H05K 7/14, H02G 5/06, H05K 7/20

(54) **Elektrische Vorrichtung**
Electrical device
Dispositif électrique

(30) Priorität: 21.08.2004 DE 102004040592
(43) Veröffentlichungstag der Anmeldung: 22.02.2006
(73) Patentinhaber: ROBERT BOSCH GMBH, 70442 Stuttgart (DE)
(72) Erfinder: Miller, Hans-Peter, 70374 Stuttgart (DE); Doeffinger, Andreas, 71229 Leonberg (DE)

(56) Entgegenhaltungen:
- DE-A1- 3 629 552
- US-A- 4 145 565

## Beschreibung

### Stand der Technik

Die Erfindung betrifft eine elektrische Vorrichtung mit einem Gehäuse und einer Gehäuseoberfläche, wobei die Gehäuseoberfläche abschnittsweise von zumindest zwei in dem Gehäuse aufgenommenen elektrischen Leitern unterbrochen ist. Bekannte elektrische Vorrichtungen dieser Art bestehen aus einem Gehäuse, in das ein Kühlkörper aus Aluminiumdruckguss integriert ist. Die Integration ist dabei derart, dass der Druckgusskühlkörper in eine Spritzgussform eingesetzt wird und dieser Kühlkörper von Kunststoffspritzgussmaße abschnittsweise umspritzt wird. Durch dieses abschnittsweise Umspritzen entsteht ein verhältnismäßig sicherer und dichter Verbund zwischen Kühlkörper und erstarrtem Kunststoffgehäuse. Es befinden sich dabei weitere Einlegeteile in dem Gehäuse, sogenannte Stanzgitter, die als Leiterbahnen in dem Gehäuse funktionieren. Diese Leiterbahnen enden in einem ausreichenden Abstand vor einer in dem Kunststoffgehäuse vorgesehenen Öffnung, sodass die Öffnung insgesamt einen geschlossenen rechteckigen Kunststoffrand aufweist. In diese Öffnung ragt ein Podest des Kühlkörpers, auf das ein Substratträger (LBS) aufgesetzt ist. Das Substrat auf dem Substratträger ist mit Bonddrähten an die bereits erwähnten Leiterbahnen kontaktiert. Bei dieser Ausführung ist nachteilig, dass der erwähnte verhältnismäßig breite Kunststoffrahmen einer weiteren kompakteren Gestaltung dieser elektrischen Vorrichtung entgegensteht.

### Vorteile der Erfindung

Die erfindungsgemäße elektrische Vorrichtung mit den Merkmalen des Hauptanspruchs hat den Vorteil, dass durch das Vorsehen von zumindest zwei Abstandshaltern zwischen den elektrischen Leitern und einem weiteren leitfähigen Körper ein Kurzschluss zwischen dem leitfähigen Körper und den Leitern sicher verhindert werden kann. Darüber hinaus ermöglicht diese Art der Gestaltung eine weitere Verkleinerung der elektrischen Vorrichtung.

Durch die in den Unteransprüchen aufgeführten Maßnahmen sind vorteilhafte Weiterbildungen der elektrischen Vorrichtung nach dem Hauptanspruch möglich.

Besonders einfach und kostengünstig ist die Vorrichtung, wenn die zumindest zwei Abstandshalter einstückig mit dem Gehäuse verbunden sind, der Teileaufwand ist reduziert.

Lässt man es zu, dass die zumindest zwei Leiter in einer Manteloberfläche einer Öffnung aus dem Gehäuse hervortreten und der leitfähige Körper in die Öffnung eingesetzt ist, so können einerseits bei an sich unisolierten Enden der Leiter kürzestmögliche kurzschlussfreie Abstände zwischen den Leitern und dem leitfähigen Körper ermöglicht werden. Darüber hinaus ermöglicht diese Art der Gestaltung der zumindest zwei Leiter, dass diese in der Öffnung auf ein notwendiges Maß gekürzt werden können. Bevor der leitfähige Körper in die Öffnung gesetzt wird, können beispielsweise die Leiter rund um die Öffnung noch durch ein gemeinsames Mittelteil verbunden sein, dass beispielsweise durch einen Stanzvorgang aus der Öffnung geschnitten wird. Dadurch dass die Leiter durch ein Mittelteil zunächst verbunden sind, ergeben sich auch hinsichtlich des Fertigungsvorgangs des Gehäuses Vorteile, da die Leiter somit leicht an Ort und Stelle gehalten werden - trotz der hohen Drücke beim Spritzgießen des Gehäuses. Die Qualität der Leiteranordnung wird dadurch verbessert.

### Zeichnungen

In den Zeichnungen sind Ausführungsbeispiele einer erfindungsgemäßen elektrischen Vorrichtung dargestellt. Es zeigen:
Figur 1 eine Draufsicht auf das offene Gehäuse,
Figur 2 eine Detailansicht der Fuge zwischen Gehäuse und Podest,
Figur 3 eine Detailansicht eines zwei Leiter überspannenden zweiten Substrats,
Figur 4 eine Schnittdarstellung durch die bereits erwähnte Fuge.

### Beschreibung

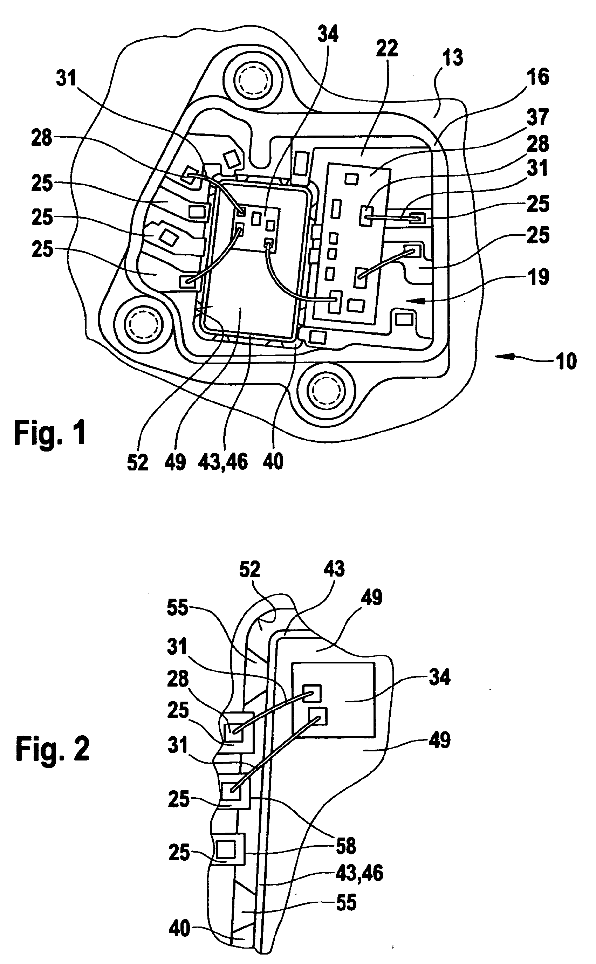

In Figur 1 ist eine Draufsicht auf die elektrische Vorrichtung 10 dargestellt. Ausschnittweise ist ein Gehäuse 13 gezeigt, das eine Wandung 16 trägt, die einen Gehäuseinnenraum 19 begrenzt. Der Gehäuseinnenraum 19 wird auf seiner Unterseite durch eine Gehäusebodenoberfläche 22 begrenzt. Die Gehäusebodenoberfläche 22 wird zum großen Teil durch eine Kunststoffoberfläche des Kunststoffgehäuses gebildet. Abschnittsweise ist die Gehäusebodenoberfläche 22 jedoch durch zumindest 2 in dem Gehäuse 13 aufgenommenen elektrischen Leitern 25 unterbrochen. Die Leiter 25 sind sogenannte Einlegeteile, die vor dem eigentlichen Spritzvorgang für das Gehäuse 13 in die Spritzgussform eingelegt werden, um anschließend zumindest abschnittsweise durch die Kunststoffmasse des Gehäuses 13 umspritzt zu werden. Die Leiter 25 weisen auf ihrer Oberfläche sogenannte Bond-Pads 28 auf, über die mittels sogenannter Bonddrähte 31 ein erstes Substrat 34 elektrisch verbunden ist. Mittels dieser Bonddrähte 31 ist in diesem Beispiel ein optionales zweites Substrat elektrisch kontaktiert.

Der Gehäuseinnenraum 19 hat nicht nur die durch die Wandung 16 begrenzte Gehäuseöffnung, sondern hat darüber hinaus eine Bodenöffnung 40, die im Beispiel im wesentlichen rechteckig ist und die durch ein Podest 43 eine Kühlkörpers 46 im wesentlichen verschlossen ist. Der Kühlkörper 46 liegt an der hier nichtdargestellten Rückseite des Gehäuses 13 flächig und dicht schließend an. Auf dem Podest 43 sitzt in diesem Ausführungsbeispiel ein Substratträger 49 auf, der beispielsweise als LBS ausgeführt sein kann. Dieser Substratträger 49 trägt das erste Substrat 34. Die Bodenöffnung 40 hat eine Manteloberfläche 52, die im Beispiel dem Substratträger 49 zugewandt ist.

Wie in vergrößerter Darstellung in Figur 2 erkennbar ist, ragen im Beispiel drei Leiter 25 über die Manteloberfläche 52 hinaus und könnten ohne besondere Maßnahmen bei ungenauer Lage des Podests 43 oder ungenauer Lage des Substratträgers 49 dieses oder diesen kontaktieren. Da sowohl das Podest 43 als auch der Substratträger 49 elektrisch leitfähig, weil metallisch, sind, könnte das Problem auftreten, dass benachbarte in die Öffnung 40 hineinragende Leiter 25 durch das Podest 43 oder den Substratträger 49 kurzgeschlossen würden. Dies hätte zur Folge, dass unter Umständen beispielsweise die auf dem ersten Substrat 34 angeordnete Schaltung nicht funktionieren würde. Es ist daher vorgesehen, dass der leitfähige Körper, sei es das Podest 43, sei es der Substratträger 49 durch zumindest zwei Abstandshalter 55 von den Leitern 25 beabstandet gehalten ist.

Mit insgesamt acht Abstandshaltern 55 - zwei auf jeder Seite der rechteckigen Öffnung 40 - wird im Ausführungsbeispiel nach Figur 1 sichergestellt, dass Kurzschlüsse zwischen dem Podest 43 und/oder dem Substratträger 49, auf dem das Substrat 34, beispielsweise eine elektronische Reglereinheit, befestigt ist, und den Leitern 25 ausgeschlossen sind. Für die Abstandshalter 55 wird vorzugsweise ein Höhe von 0,3 bis 0,5 mm vorgesehen.

Es ist somit eine elektrische Vorrichtung 10 vorgesehen, mit einem Gehäuse 13 und einer Gehäuseoberfläche 22, 52, wobei die Gehäuseoberfläche 22, 52 abschnittsweise von zumindest zwei in dem Gehäuse 13 aufgenommenen elektrischen Leitern 25 unterbrochen ist und die Leiter an der unterbrochenen Gehäuseoberfläche 22, 52 von einem leitfähigen Körper 43, 46 überdeckt sind, wobei der leitfähige Körper 43, 46 durch zumindest zwei Abstandshalter 55 von den Leitern 25 beabstandet gehalten ist.

Es ist vorgesehen, dass die zumindest zwei Abstandshalter einstückig mit dem Gehäuse 13 verbunden sind.

Es ist weiterhin vorgesehen, dass die zumindest zwei Leiter 25 aus der Manteloberfläche 52 der Öffnung 40 hervortreten und der leitfähige Körper, sei es der Kühlköper 46 mit seinem Podest 43 oder der Substratträger 49, in der Öffnung 40 sitzt.

Wie bereits angedeutet, spielt es für die Funktion der Abstandshalter 55 keine Rolle, ob der leitfähige Körper ein Podest 43 eine Kühlkörpers 46 oder ein auf dem Podest befestigter weiterer leitfähiger Körper wie beispielsweise der Substratträger 49 ist.

Die in Figur 2 dargestellten Leiter 25 ragen unter anderem deshalb in die Öffnung 40, weil diese Leiter 25 in der Öffnung 40 mittels eines Stanzverfahrens auf die dort dargestellte Länge gekürzt sind. Die Leiter 25 ragen somit mit ihren Stanzkanten 58 in die Öffnung 40.

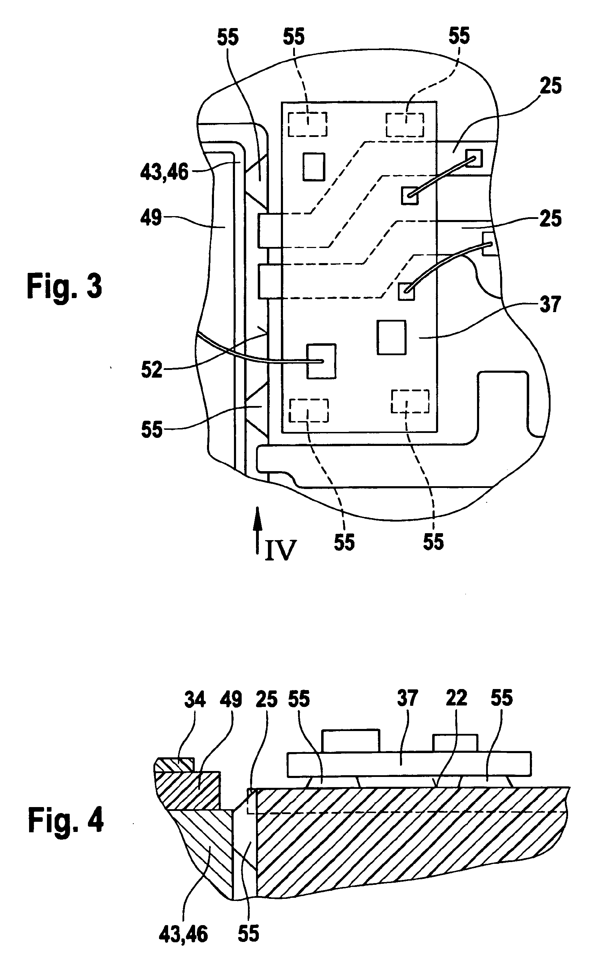

In Figur 3 ist eine Draufsicht auf das zweite Substrat 37 in vergößerter Ansicht dargestellt. Wie hier zu erkennen ist, unterqueren zwei Leiter 25 das zweite Substrat 37 als einen leitfähigen Körper. Damit der leitfähige Körper, das Substrat 37, nicht die beiden Leiter 25 kontaktiert, ist vorgesehen, in diesem Ausführungsbeispiel insgesamt vier Abstandshalter 55 vorzusehen, damit das Substrat 37 gut oberhalb der Leiter 25 angeordnet ist. Das Substrat 37 kann beispielsweise mittels eines Klebstoffs an der vorgesehenen Stelle befestigt sein. Da die beiden in Figur 3 dargestellten Leiter 25 ebenso in der Öffnung 40 aus der Manteloberfläche 52 heraustreten, sind auch auf dieser Seite der Öffnung 40 zwei Abstandshalter 55 vorzusehen, damit das Podest 43 oder der Substratträger 49 die beiden Leiter 25 nicht kontaktieren und gar einen Kurzschluss erzeugen kann.

Figur 4 zeigt eine Schnittansicht, wie in Figur 3 angegeben. Figur 4 verdeutlicht den durch die Abstandshalter erzeugten Effekt, wonach diese eine Kontaktierung des Podests 43 des Kühlkörpers 46 oder eines gegebenenfalls etwas tiefer angeordneten Substratträgers 49 mit dem Leiter 25 verhindern. Ebenso wird hier deutlich, wie die aus der Gehäusebodenoberfläche 22 heraustretenden Abstandshalter 55 das zweite Substrat 37 tragen und so zuverlässig einen Kurzschluss unterhalb des zweiten Substrats 37 verhindern. Diese in Figur 4 dargestellte Art der Anordnung des zweiten Substrats 37 führt aber auch dazu, dass eine isolierende und mechanisch nahezu spannungsfreie Verbindung des zweiten Substrats 37, beispielsweise als ein LTCC, zum Kunststoffgehäuse, ganz besonders zur Gehäusebodenoberfläche 22 gewährleistet wird. Als geeignete Höhe für diese Abstandshalter 55 hat sich ein Maß zwischen 0,075 mm und 0,4 mm erwiesen. Die Abstandshalter 55 können beispielsweise als Zylinder oder Kegelstumpf oder eine andere Form realisiert sein.

Es ist vorgesehen, dass die elektrische Vorrichtung 10 als ein Regler eines Drehstromgenerators für Kraftfahrzeuge ausgeführt ist.

## Patentansprüche

1. Elektrische Vorrichtung (10) mit einem Gehäuse (13) und einer Gehäuseoberfläche (22, 52), wobei die Gehäuseoberfläche (22, 52) abschnittsweise von zumindest zwei in dem Gehäuse (13) aufgenommenen elektrischen Leitern (25) unterbrochen ist und die Leiter (25) an der unterbrochenen Gehäuseoberfläche (22, 52) von einem leitfähigen Körper (43, 46, 49, 34) überdeckt sind und der leitfähige Körper (43, 46, 49, 34) durch zumindest zwei Abstandshalter (55) von den Leitern (25) beabstandet gehalten ist.

2. Elektrische Vorrichtung nach Anspruch 1, **dadurch gekennzeichnet, dass** die zumindest zwei Abstandshalter (55) einstückig mit dem Gehäuse (13) verbunden sind.

3. Elektrische Vorrichtung nach Anspruch 1 oder 2, **dadurch gekennzeichnet, dass** die zumindest zwei Leiter (25) aus einer Manteloberfläche (52) einer Öffnung (40) des Gehäuses hervortreten und der leitfähige Körper (43, 46, 49) in der Öffnung (40) sitzt.

4. Elektrische Vorrichtung nach einem der vorherstehenden Ansprüche, **dadurch gekennzeichnet, dass** der leitfähige Körper ein Podest (43) eines Kühlkörpers (46) oder ein auf dem Podest (43) befestigter weiterer leitfähiger Körper (49) ist.

5. Elektrische Vorrichtung nach einem der vorstehenden Ansprüche, **dadurch gekennzeichnet, dass** die Leiter (25) mit Stanzkanten (58) in die Öffnung (40) ragen.

## Claims

1. Electrical device (10) having a housing (13) and a housing surface (22, 52), the housing surface (22, 52) being interrupted in sections by at least two electrical conductors (25), which are accommodated in the housing (13), and the conductors (25) being covered on the interrupted housing surface (22, 52) by a conductive body (43, 46, 49, 34), and the conductive body (43, 46, 49, 34) being held such that it is spaced apart from the conductors (25) by at least two spacers (55).

2. Electrical device according to Claim 1, **characterized in that** the at least two spacers (55) are integrally connected to the housing (13).

3. Electrical device according to Claim 1 or 2, **characterized in that** the at least two conductors (25) protrude out of an outer surface (52) of an opening (40) in the housing, and the conductive body (43, 46, 49) rests in the opening (40).

4. Electrical device according to one of the preceding claims, **characterized in that** the conductive body is a platform (43) of a heat sink (46) or is a further conductive body (49), which is fixed on the platform (43) .

5. Electrical device according to one of the preceding claims, **characterized in that** the conductors (25) protrude with punched edges (58) into the opening (40).

## Revendications

1. Dispositif électrique (10) comprenant un boîtier (13) et une surface de boîtier (22, 52) interrompue par segments par au moins deux conducteurs électriques (25) logés dans le boîtier (13), et au niveau de la surface de boîtier (22, 52) interrompue, les conducteurs (25) étant recouverts par un corps conducteur (43, 46, 49, 34), et le corps conducteur (43, 46, 49, 34) étant écarté des conducteurs (25) par au moins deux écarteurs (55).

2. Dispositif électrique selon la revendication 1,
**caractérisé en ce qu'**
au moins deux écarteurs (55) sont d'une seule pièce avec le boîtier (13).

3. Dispositif électrique selon la revendication 1 ou 2,
**caractérisé en ce qu'**
au moins deux conducteurs (25) font saillie d'une surface enveloppe (52) d'une ouverture (40) du boîtier, et le corps conducteur (43, 46, 49) se situe dans l'ouverture (40).

4. Dispositif électrique selon l'une des revendications précédentes,
**caractérisé en ce que**
le corps conducteur est un piédestal (43) d'un refroidisseur (46) ou un autre corps conducteur (49) fixé sur le palier (43).

5. Dispositif électrique selon l'une des revendications précédentes,
**caractérisé en ce que**
les conducteurs (25) font saillie dans l'ouverture (40) par des arêtes découpées (58).
